(19) Europäisches Patentamt / European Patent Office / Office européen des brevets

(11) EP 4 657 518 A1

(12) **EUROPEAN PATENT APPLICATION**
published in accordance with Art. 153(4) EPC

(43) Date of publication:
03.12.2025 Bulletin 2025/49

(21) Application number: 24779638.6

(22) Date of filing: 18.03.2024

(51) International Patent Classification (IPC):
H01L 23/373 (2006.01)   C01B 21/064 (2006.01)
C01B 33/12 (2006.01)   C08K 3/38 (2006.01)
C08L 83/04 (2006.01)

(52) Cooperative Patent Classification (CPC):
C01B 21/064; C01B 33/12; C08K 3/38;
C08L 83/04; H01L 23/373

(86) International application number:
PCT/JP2024/010452

(87) International publication number:
WO 2024/203513 (03.10.2024 Gazette 2024/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 27.03.2023 JP 2023049555

(71) Applicant: Denka Company Limited
Tokyo 103-8338 (JP)

(72) Inventors:
• SASAKI, Yusuke
Tokyo 103-8338 (JP)
• FUKAO, Kenji
Tokyo 103-8338 (JP)

(74) Representative: Gulde & Partner
Patent- und Rechtsanwaltskanzlei mbB
Berliner Freiheit 2
10785 Berlin (DE)

(54) **THERMALLY CONDUCTIVE SHEET AND AGGREGATED BORON NITRIDE PARTICLES**

(57) A thermally conductive sheet of the present invention contains aggregated boron nitride particles in which primary particles are aggregated, a silicone resin, and an unreacted silicone oil. According to the present invention, a thermally conductive sheet excellent in thermal conductivity and flexibility can be provided.

*FIG. 1*

**Description**

Technical Field

The present invention relates to a thermally conductive sheet and aggregated boron nitride particles used in the thermally conductive sheet.

Background Art

In heat generating electronic components such as a power device, a transistor, a thyristor, and a CPU, an important problem is how to effectively dissipate heat generated during use. Conventionally, measures for dissipating of heat have been generally taken: (1) enhancing heat conductivity of an insulating layer of a printed wiring board on which a heat generating electronic component is mounted, and (2) attaching a heat generating electronic component or a printed wiring board on which a heat generating electronic component is mounted to a heat sink via electrically insulating thermal interface materials. As an insulating layer of a printed wiring board and a thermal interface material, a silicone resin or an epoxy resin filled with ceramic powder has been used.

As the ceramic powder, a boron nitride powder having properties such as high heat conductivity, high insulation property, and low dielectric constant is attracting attention. For example, Patent Literature 1 discloses a boron nitride powder formed by an aggregation of primary particles of boron nitride, the boron nitride powder having a peak A existing in a range of 5 μm or more and less than 30 μm and a peak B existing in a range of 50 μm or more and less than 100 μm, in a volume-based particle size distribution.

Citation List

Patent Literature

Patent Literature 1: JP 2020-164365 A

Summary of Invention

Technical Problem

Using the boron nitride powder described in Patent Literature 1, a thermally conductive sheet excellent in thermal conductivity and insulation property can be obtained. However, with recent size reduction of electronic devices and increase in the amount of heat generated by heat generating electronic components, a thermally conductive sheet further excellent in thermal conductivity is required. With the complication of electronic devices in recent years, there is a case where a heat generating electronic component is mounted on a mounting surface having a step, and excellent flexibility is required for a thermally conductive sheet.

Therefore, an object of the present invention is to provide a thermally conductive sheet excellent in thermal conductivity and flexibility, and aggregated boron nitride particles used in the thermally conductive sheet.

Solution to Problem

The present inventors have intensively studied to achieve the above object, and as a result, the above object can be achieved by using an unreacted silicone oil.

The present invention is based on the above knowledge and its gist is as below.

[1] A thermally conductive sheet including: aggregated boron nitride particles in which primary particles are aggregated; a silicone resin; and an unreacted silicone oil.

[2] The thermally conductive sheet described in [1], wherein a crushing strength of the aggregated boron nitride particles is 5 to 15 MPa.

[3] The thermally conductive sheet described in [1] or [2], wherein the silicone resin is a radically curable silicone resin.

[4] The thermally conductive sheet described in any one of [1] to [3], wherein a content of the unreacted silicone oil is 1 to 15 mass%.

[5] Aggregated boron nitride particles for the thermally conductive sheet described in any one of [1] to [4].

Advantageous Effects of Invention

According to the present invention, it is possible to provide a thermally conductive sheet excellent in thermal conductivity and flexibility, and aggregated boron nitride particles used in the thermally conductive sheet.

Brief Description of Drawings

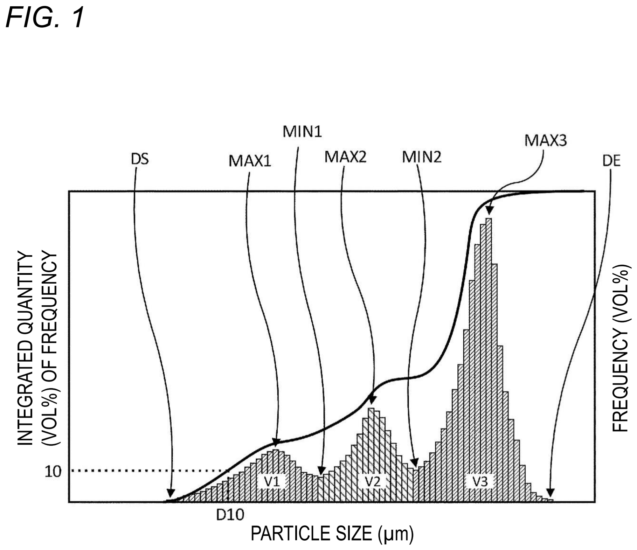

Fig. 1 is a conceptual diagram of a particle size distribution of a thermally conductive filler.

Description of Embodiments

[Thermally Conductive Sheet]

A thermally conductive sheet of the present invention contains aggregated boron nitride particles in which primary particles are aggregated, a silicone resin, and an unreacted silicone oil. Thereby, the thermal conductivity and the flexibility of the thermally conductive sheet can be improved.

(Thermally Conductive Filler)

The thermally conductive sheet of the present invention contains a thermally conductive filler. The thermally conductive filler contains aggregated boron nitride particles in which primary particles are aggregated. Therefore, the thermally conductive sheet of the present invention contains aggregated boron nitride particles in which primary particles are aggregated. Thereby, the thermal conductivity of the thermally conductive sheet can be improved.

The thermally conductive filler may contain a thermally conductive filler other than the aggregated boron nitride particles in which primary particles are aggregated. Examples of the thermally conductive filler other than the aggregated boron nitride particles include, for example, boron nitride primary particles that are not aggregated, aluminum nitride particles, aluminum oxide particles, silicon carbide particles, aluminum nitride, and magnesium oxide.

The content of the aggregated boron nitride particles in the thermally conductive filler is preferably 50 to 100 vol%, more preferably 60 to 95 vol%, and still more preferably 70 to 90 vol%.

<Crushing Strength of Aggregated Boron Nitride Particles>

The crushing strength of the aggregated boron nitride particles in which primary particles are aggregated used in the thermally conductive sheet of the present invention is preferably 5 to 15 MPa. When the crushing strength of the aggregated boron nitride particles is 5 MPa or more, it is possible to prevent the aggregated boron nitride particles from collapsing during the preparation of the thermally conductive sheet and to suppress a decrease in heat conductivity of the thermally conductive sheet. When the crushing strength of the aggregated particles in which primary particles are aggregated is 15 MPa or less, voids in the sheet can be reduced by deformation of the aggregated boron nitride particles, and the thermal conductivity can be further improved. From such a viewpoint, the crushing strength of the aggregated boron nitride particles is more preferably 6 to 13 MPa and still more preferably 7 to 11 MPa. The crushing strength of the aggregated boron nitride particles in which primary particles are aggregated can be measured by the method described in Examples described later.

<Particle Size Distribution of Thermally Conductive Filler>

The particle size distribution of the thermally conductive filler is not particularly limited. For example, the particle size distribution of the thermally conductive filler used in the thermally conductive sheet of the present invention may have only a first maximum point, and may have only the first maximum point and a second maximum point at which the particle size is larger than at the first maximum point. However, as shown in Fig. 1, the particle size distribution of the thermally conductive filler used in the thermally conductive sheet of the present invention preferably has at least a first maximum point (MAX1), a second maximum point (MAX2) at which the particle size is larger than at the first maximum point (MAX1), and a third maximum point (MAX3) at which the particle size is larger than at the second maximum point (MAX2). It is preferable that the particle size at the first maximum point (MAX1) is 0.4 $\mu$m or more and less than 10 $\mu$m, the particle size at the second maximum point (MAX2) is 10 $\mu$m or more and less than 40 $\mu$m, and the particle size at the third maximum point (MAX3) is 40 $\mu$m or more and 110 $\mu$m or less. Thereby, the filling property of the thermally conductive filler in the thermally conductive sheet can be enhanced, and the thermal conductivity of the thermally conductive sheet can be further improved. The particle size distribution of the thermally conductive filler used in the thermally conductive sheet of the present invention can be measured by the method of Examples described later.

The particle size at the first maximum point (MAX1) is preferably 0.4 μm or more and less than 10 μm. When the particle size at the first maximum point (MAX1) is 0.4 μm or more and less than 10 μm, the filling property of the thermally conductive filler in the thermally conductive sheet can be further enhanced, and the thermal conductivity of the thermally conductive sheet can be further improved. From such a viewpoint, the particle size of the first maximum point (MAX1) is more preferably 1.0 to 9.0 μm and still more preferably 2.0 to 8.0 μm.

The particle size at the second maximum point (MAX2) is preferably 10 μm or more and less than 40 μm. When the particle size at the second maximum point (MAX2) is 10 μm or more and less than 40 μm, the filling property of the thermally conductive filler in the thermally conductive sheet can be further enhanced, and the thermal conductivity of the thermally conductive sheet can be further improved. From such a viewpoint, the particle size of the second maximum point (MAX2) is more preferably 15 to 36 μm and still more preferably 18 to 30 μm.

The particle size at the third maximum point (MAX3) is preferably 40 to 110 μm. When the particle size at the third maximum point (MAX3) is 40 to 110 μm, the filling property of the thermally conductive filler in the thermally conductive sheet can be further enhanced, and the thermal conductivity of the thermally conductive sheet can be further improved. From such a viewpoint, the particle size of the third maximum point (MAX3) is more preferably 50 to 100 μm and still more preferably 65 to 90 μm.

An integrated quantity (V1) of a frequency between a peak start and a peak end in the peak having the first maximum point (MAX1) is preferably 1 to 27 vol%. When the integrated quantity (V1) is 1 to 27 vol%, the filling property of the thermally conductive filler in the thermally conductive sheet can be further enhanced, and the thermal conductivity of the thermally conductive sheet can be further improved. From such a viewpoint, the integrated quantity (V1) is more preferably 5 to 20 vol%. The peak start in the peak having the first maximum point (MAX1) is a minimum point existing on the side where the particle size is smaller with respect to the first maximum point (MAX1). When there is no minimum point on the side where the particle size is smaller with respect to the first maximum point (MAX1), the peak start is an end (DS) of the particle size distribution on the side where the particle size is smaller. The peak end in the peak having the first maximum point (MAX1) is a minimum point (MIN1) existing on the side where the particle size is larger with respect to the first maximum point (MAX1). The integrated quantity (V1) of the frequency is a value obtained by subtracting the frequency of the particle size at the minimum point (MIN1) existing on the side where the particle size is larger with respect to the first maximum point (MAX1) from the integrated quantity of the frequency of from the particle size of the minimum point existing on the side where the particle size is smaller with respect to the first maximum point (MAX1) or the particle size at the end (DS) of the particle size distribution on the side where the particle size is smaller to the particle size of the minimum point (MIN1) existing on the side where the particle size is larger with respect to the first maximum point (MAX1). The reason for subtracting the frequency of the particle size at the minimum point (MIN1) existing on the side where the particle size is larger with respect to the first maximum point (MAX1) is to prevent the frequency of the particle size at the minimum point (MIN1) existing on the side where the particle size is larger with respect to the first maximum point (MAX1) from being added to both the integrated quantity of the frequency between the peak start and the peak end in the peak having the first maximum point (MAX1) and an integrated quantity of a frequency between a peak start and a peak end in the peak having the second maximum point (MAX2).

An integrated quantity (V2) of a frequency between a peak start and a peak end in the peak having the second maximum point (MAX2) is preferably 5 to 40 vol%. When the integrated quantity (V2) is 5 to 40 vol%, the filling property of the thermally conductive filler in the thermally conductive sheet can be further enhanced, and the thermal conductivity of the thermally conductive sheet can be further improved. From such a viewpoint, the integrated quantity (V2) is more preferably 10 to 30 vol%. The peak start in the peak having the second maximum point (MAX2) is the minimum point (MIN1) existing on the side where the particle size is smaller with respect to the second maximum point (MAX2). The peak end in the peak having the second maximum point (MAX2) is the minimum point (MIN2) existing on the side where the particle size is larger with respect to the second maximum point (MAX2). The integrated quantity (V2) of the frequency is a value obtained by subtracting the frequency of the particle size at the minimum point (MIN2) existing on the side where the particle size is larger with respect to the second maximum point (MAX2) from the integrated quantity of the frequency of from the particle size at the minimum point (MIN1) existing on the side where the particle size is smaller with respect to the second maximum point (MAX2) to the particle size of the minimum point (MIN2) existing on the side where the particle size is larger with respect to the second maximum point (MAX2). The reason for subtracting the frequency of the particle size at the minimum point (MIN2) existing on the side where the particle size is larger with respect to the second maximum point (MAX2) is to prevent the frequency of the particle size at the minimum point (MIN2) existing on the side where the particle size is larger with respect to the second maximum point (MAX2) from being added to both the integrated quantity of the frequency between the peak start and the peak end in the peak having the second maximum point (MAX2) and an integrated quantity of a frequency between a peak start and a peak end in the peak having the third maximum point (MAX3).

An integrated quantity (V3) of a frequency between a peak start and a peak end in the peak having the third maximum point (MAX3) is preferably 50 to 90 vol%. When the integrated quantity (V3) is 50 to 90 vol%, the filling property of the thermally conductive filler in the thermally conductive sheet can be further enhanced, and the thermal conductivity of the thermally conductive sheet can be further improved. From such a viewpoint, the integrated quantity (V3) is more preferably 60 to 80 vol%. The peak start in the peak having the third maximum point (MAX3) is the minimum point (MIN2) existing on the side where the particle size is smaller with respect to the third maximum point (MAX3). The peak end in the peak having the third maximum point (MAX3) is a minimum point existing on the side where the particle size is larger with respect to the third maximum point (MAX3). When there is no minimum point on the side where the particle size is larger with respect to the third maximum point (MAX3), the peak end is an end (DE) of the particle size distribution on the side where the particle size is larger. The integrated quantity (V3) of the frequency is a value obtained by subtracting the frequency of the particle size at the minimum point existing on the side where the particle size is larger with respect to the third maximum point (MAX3) from the integrated quantity of the frequency of from the particle size at the minimum point (MIN2) existing on the side where the particle size is smaller with respect to the third maximum point (MAX3) to the particle size at the minimum point existing on the side where the particle size is larger with respect to the third maximum point (MAX3), or an integrated quantity of the frequency of from the particle size at the minimum point (MIN2) existing on the side where the particle size is smaller with respect to the third maximum point (MAX3) to the particle size at the end (DE) of the particle size distribution on the side where the particle size is larger. The reason for subtracting the frequency of the particle size at the minimum point existing on the side where the particle size is larger with respect to the third maximum point (MAX3) is to prevent the frequency of the particle size at the minimum point existing on the side where the particle size is larger with respect to the third maximum point (MAX3) from being added to both the integrated quantity of the frequency between the peak start and the peak end in the peak having the third maximum point (MAX3) and an integrated quantity of a frequency between a peak start and a peak end in the peak having the maximum point existing on the side where the particle size is larger with respect to the third maximum point, which is adjacent to the third maximum point (MAX3).

As long as the filling property of the thermally conductive filler in the thermally conductive sheet can be enhanced, the particle size distribution of the thermally conductive filler used in the thermally conductive sheet of the present invention may have other maximum points in addition to the above-described first to third maximum points.

<Method for Producing Thermally Conductive Filler>

An example of a method for producing a thermally conductive filler used in the thermally conductive sheet of the present invention will be described below.

The thermally conductive filler used in the thermally conductive sheet of the present invention can be produced, for example, by preparing a first thermally conductive filler having a particle size distribution of the first maximum point, a second thermally conductive filler having a particle size distribution of the second maximum point, and a third thermally conductive filler having a particle size distribution of the third maximum point, respectively, and mixing the prepared first to third thermally conductive fillers.

Among the first to third thermally conductive fillers, the second and third thermally conductive fillers each preferably contain at least aggregated boron nitride particles. The first thermally conductive filler may be aggregated boron nitride particles, but is preferably hexagonal boron nitride primary particles. The maximum point of each of the first to third thermally conductive fillers means an apex of a peak in the particle size distribution of each of the first to third thermally conductive fillers. The particle size distribution of the first to third thermally conductive fillers is measured in the same manner as the particle size distribution of the thermally conductive filler described above.

In a mixing step, the first to third thermally conductive fillers may be mixed such that the volume ratio of the third thermally conductive filler is larger than the volume ratio of the first thermally conductive filler and the volume ratio of the second thermally conductive filler. Thereby, the filling property of the thermally conductive filler can be further enhanced. From the viewpoint of improving the heat conductivity of the thermally conductive sheet, the volume ratio of the third thermally conductive filler is preferably 50 to 90 parts by volume and more preferably 60 to 80 parts by volume with respect to 100 parts by volume of the total of the first to third thermally conductive fillers. From the viewpoint of improving the heat conductivity of the thermally conductive sheet, the volume ratio of the second thermally conductive filler is preferably 5 to 40 parts by volume and more preferably 10 to 30 parts by volume with respect to 100 parts by volume of the total of the first to third thermally conductive fillers. From the viewpoint of improving the heat conductivity of the thermally conductive sheet, the volume ratio of the first thermally conductive filler is preferably 1 to 27 parts by volume and more preferably 5 to 20 parts by volume with respect to 100 parts by volume of the total of the first to third thermally conductive fillers.

Each of the lump-shaped boron nitride particles used as the aggregated boron nitride particles can be produced, for example, by a production method including a pulverization step of pulverizing a lump-shaped boron carbide, a nitridation step of nitriding the pulverized boron carbide to obtain boron carbonitride, and a decarburization step of decarburizing the boron carbonitride.

In the pulverization step, lump-shaped boron carbide (boron carbide lump) is pulverized using a general pulverizer or crusher. At this time, for example, a boron carbide powder having a desired maximum point can be obtained by adjusting a pulverization time and a feeding amount of the boron carbide lump. The maximum point of the boron carbide powder can be measured in the same manner as the maximum point of the boron nitride particles described above. By adjusting the maximum point of the boron carbide powder to reach the desired maximum point of the boron nitride particles, first to third boron nitride particles having the above-described maximum points are obtained.

Subsequently, in the nitridation step, boron carbonitride is obtained by firing a boron carbide powder in an atmosphere advancing the nitridation reaction and under a pressurized condition.

The atmosphere in the nitridation step is an atmosphere advancing the nitridation reaction, and may be, for example, nitrogen gas, ammonia gas, or the like, and may be one kind of these alone or a combination of two or more kinds thereof. The atmosphere is preferably nitrogen gas from the viewpoint of the ease of nitridation and the cost. The content of the nitrogen gas in the atmosphere is preferably 95 vol% or more and more preferably 99.9 vol% or more.

The pressure in the nitridation step is preferably 0.6 MPa or more and more preferably 0.7 MPa or more, and is preferably 1.0 MPa or less and more preferably 0.9 MPa or less. The pressure is still more preferably 0.7 to 1.0 MPa. The firing temperature in the nitridation step is preferably 1800°C or higher and more preferably 1900°C or higher, and is preferably 2400°C or lower and more preferably 2200°C or lower. The firing temperature is still more preferably 1800 to 2200°C. The pressure condition and the firing temperature are preferably 1800°C or higher and 0.7 to 1.0 MPa because it is a condition advancing the nitridation of the boron carbide more suitably and being industrially appropriate, too.

The firing time in the nitridation step is appropriately selected in a range where the nitridation proceeds sufficiently, and is preferably 6 hours or more and more preferably 8 hours or more, and may be preferably 30 hours or less and more preferably 20 hours or less.

In the decarburization step, the boron carbonitride obtained in the nitridation step is subjected to a heat treatment of retaining in an atmosphere equal to or more than normal pressure at a predetermined retaining temperature for a certain period of time. Thereby, lump-shaped boron nitride particles formed by an aggregation of decarburized and crystallized hexagonal boron nitride primary particles can be obtained.

The atmosphere in the decarburization step is an atmosphere of normal pressure (atmospheric pressure) or a pressurized atmosphere. In the case of the pressurized atmosphere, the pressure may be, for example, 0.5 MPa or less and preferably 0.3 MPa or less.

In the decarburization step, for example, the temperature is raised first to a predetermined temperature (temperature at which the decarburization can start) and then further raised to the retaining temperature at a predetermined temperature raising rate. The predetermined temperature (temperature at which the decarburization can start) can be set according to the system, and, for example, may be 1000°C or higher and may be 1500°C or lower, and is preferably 1200°C or lower. The rate at which the temperature is raised from the predetermined temperature (temperature at which the decarburization can start) to the retaining temperature may be, for example, 5°C/min or less, and may be preferably 4°C/min or less, 3°C/min or less, or 2°C/min or less.

From the viewpoint that a particle growth is easy to occur favorably and the heat conductivity of the boron nitride particles to be obtained can be further improved, the retaining temperature is preferably 1800°C or higher and more preferably 2000°C or higher. The retaining temperature is preferably 2200°C or lower and more preferably 2100°C or lower.

The retaining time at the retaining temperature is appropriately selected in a range where the crystallization proceeds sufficiently, and may be, for example, more than 0.5 hours, and from the viewpoint that a particle growth is easy to occur favorably, the retaining time is preferably 1 hour or more, more preferably 3 hours or more, still more preferably 5 hours or more, and particularly preferably 10 hours or more. The retaining time at the retaining temperature may be, for example, less than 40 hours, and from the viewpoint that it is possible to prevent the particle growth from proceeding too much to decrease particle strength and the cost is reduced, the retaining time is preferably 30 hours or less and more preferably 20 hours or less.

In the decarburization step, a boron source may be mixed as a raw material in addition to the boron carbonitride obtained in the nitridation step to perform decarburization and crystallization. Examples of the boron source include boric acid, boron oxide, and a mixture thereof. In this case, other additives used in the art may be further used as necessary.

The mixing ratio of the boron carbonitride and the boron source is appropriately selected. When boric acid or boron oxide is used as the boron source, the ratio of the boric acid or boron oxide may be, for example, 100 parts by mass or more and is preferably 150 parts by mass or more, and may be, for example, 300 parts by mass or less and is preferably 250 parts by mass or less, with respect to 100 parts by mass of the boron carbonitride.

The boron nitride particles obtained as described above may be subjected to a step of classification (classification step) using a sieve such that boron nitride particles having a desired particle size distribution can be obtained. Thereby, first to third lump-shaped boron nitride particles that can be used as the first to third thermally conductive fillers can be obtained.

A blended product having a particle size distribution having the above-described first to third maximum points can be obtained by mixing the obtained first to third lump-shaped boron nitride particles. A mixing method is not particularly limited as long as the first to third lump-shaped boron nitride particles can be uniformly mixed. For example, the first to third lump-shaped boron nitride particles may be mixed using a container rotating mixer, the first to third lump-shaped boron nitride particles may be mixed using a fixed container mixer, or the first to third lump-shaped boron nitride particles may be mixed using a fluid motion mixer.

(Silicone Resin)

The silicone resin used in the thermally conductive sheet of the present invention is not particularly limited as long as it is a silicone resin usually used in a thermally conductive sheet. Examples of the silicone resin used in the thermally conductive sheet of the present invention include a radically curable silicone resin cured using an organic peroxide such as an acyl-based organic peroxide or an alkyl-based organic peroxide, and an addition reaction curable silicone resin cured using a platinum catalyst. Among these silicone resins, a radically curable silicone resin is preferable. As the radically curable silicone resin, for example, a silicone polymer having a degree of polymerization of about 4000 to 10000 is used. Examples of the silicone polymer include a methylvinyl-based silicone polymer, a methylphenylvinyl-based silicone polymer, and a methylfluoroalkyl-based silicone polymer. The silicone resin may contain additives such as a silica filler and a dispersant. The content of the radically curable silicone resin in the silicone resin is preferably 80 to 100 vol%, more preferably 90 to 100 vol%, and still more preferably 95 to 100 vol%.

(Unreacted Silicone Oil)

The unreacted silicone oil used in the thermally conductive sheet of the present invention is a silicone oil having no unsaturated group. Examples of the silicone oil having no unsaturated group include methyl silicone oil in which all organic substituents are methyl groups and methyl phenyl silicone oil in which all organic substituents are methyl groups and phenyl groups. From the viewpoint of the flexibility of the thermally conductive sheet, among these silicone oils, methyl silicone oil is preferable is preferable, and dimethyl silicone oil is more preferable.

The kinematic viscosity of the unreacted silicone oil is preferably $1\times10^{-2}$ m$^2$/s or more. When the kinematic viscosity of the unreacted silicone oil is $1\times10^{-2}$ m$^2$/s or more, it is possible to suppress the unreacted silicone oil from seeping from the thermally conductive sheet. From such a viewpoint, the kinematic viscosity of the unreacted silicone oil is more preferably $5\times10^{-2}$ m$^2$/s or more and still more preferably $6\times10^{-2}$ m$^2$/s or more. From the viewpoint of further improving the flexibility of the thermally conductive sheet, the kinematic viscosity of the unreacted silicone oil is preferably 5 m$^2$/s or less, more preferably 1 m$^2$/s or less, and still more preferably 0.5 m$^2$/s or less. The kinematic viscosity of the unreacted silicone oil can be measured by the method described in Examples described later.

<Mass Average Molecular Weight>

The mass average molecular weight of the silicone resin used in the thermally conductive sheet of the present invention is preferably 30000 to 1000000, more preferably 40000 to 800000, and still more preferably 50000 to 600000. From the viewpoint of improving the flexibility of the thermally conductive sheet, the mass average molecular weight of the unreacted silicone oil is preferably 50000 to 1500000, more preferably 60000 to 1200000, and still more preferably 70000 to 1000000. The mass average molecular weights of the silicone resin and the unreacted silicone oil can be measured using gel permeation chromatography.

(Content of Thermally Conductive Filler)

The content of the thermally conductive filler in the thermally conductive sheet of the present invention is preferably 20 to 90 vol% and more preferably 25 to 85 vol% with respect of 100 vol% of the total content of the thermally conductive filler and the resin or with respect to 100 vol% of the total content of the thermally conductive filler, the silicone resin, and the unreacted silicone oil in the case of containing the unreacted silicone oil. When the content of the thermally conductive filler is 20 vol% or more, the thermal conductivity of the thermally conductive sheet tends to be further improved. When the content of the thermally conductive filler is 90 vol% or less, the dispersibility of the thermally conductive filler in the thermally conductive sheet is improved.

(Content of Unreacted Silicone Oil)

When the thermally conductive sheet of the present invention contains a silicone resin and an unreacted silicone oil, the content of the unreacted silicone oil in the thermally conductive sheet of the present invention is preferably 1 to 15 mass%. When the content of the unreacted silicone oil in the thermally conductive sheet is 1 mass% or more, the flexibility of the thermally conductive sheet is further improved, and the thermal resistance of the thermally conductive sheet can be further reduced. When the content of the unreacted silicone oil in the thermally conductive sheet is 15 mass% or less, it is possible to suppress the unreacted silicone oil from seeping from the thermally conductive sheet. From such a viewpoint, the content of the unreacted silicone oil in the thermally conductive sheet of the present invention is more preferably 2 to 12 mass% and still more preferably 5 to 8 mass%.

The content of the unreacted silicone oil in the thermally conductive sheet can be measured, for example, as follows.

An initial mass of a thermally conductive heat dissipation sheet of 50 mm × 50 mm was measured (A), and the thermally conductive heat dissipation sheet was immersed in toluene of 250 times or more the initial mass at normal temperature for 24 hours. The sample after immersion was taken out and dried in a dryer at 130°C for 2 hours to remove toluene, and a dry mass (B) was measured. The content of the unreacted silicone oil was obtained from A and B by the following formula.

Content (%) of unreacted silicone oil = (A - B)/A × 100

(Ratio of Unreacted Silicone Oil to Silicone Resin and Unreacted Silicone Oil)

When the thermally conductive sheet of the present invention contains a silicone resin and an unreacted silicone oil, a ratio of the content (vol%) of the unreacted silicone oil to the total content (vol%) of the content (vol%) of the silicone resin and the content (vol%) of the unreacted silicone oil in the thermally conductive sheet (the content of the unreacted silicone oil/(the content of the silicone resin + the content of the unreacted silicone oil)) is preferably 5 to 55%. When the proportion of the content of the unreacted silicone oil is 5% or more, the flexibility of the thermally conductive sheet can be further improved, and the thermal resistance of the thermally conductive sheet can be further reduced to improve the thermal conductivity of the thermally conductive sheet. When the proportion of the content of the unreacted silicone oil is 55% or less, insufficient curing of the thermally conductive sheet can be suppressed. From such a viewpoint, the proportion of the content of the unreacted silicone oil is more preferably 7 to 40% and still more preferably 10 to 30%.

(Storage Elastic Modulus)

The storage elastic modulus of the thermally conductive sheet of the present invention is preferably $0.3 \times 10^9$ to $1.2 \times 10^9$ Pa. When the storage elastic modulus of the thermally conductive sheet is $0.3 \times 10^9$ to $1.2 \times 10^9$ Pa, the flexibility of the thermally conductive sheet is improved, the interface thermal resistance is further reduced, and the thermal conductivity of the thermally conductive sheet can be further improved. From such a viewpoint, the storage elastic modulus of the thermally conductive sheet of the present invention is more preferably $1.1 \times 10^9$ to $0.4 \times 10^9$ Pa, still more preferably $1.0 \times 10^9$ to $0.45 \times 10^9$ Pa, and even more preferably $0.95 \times 10^9$ to $0.5 \times 10^9$ Pa. The storage elastic modulus of the thermally conductive sheet can be measured by the method described in Examples described later.

(BN Orientation Degree in Sheet)

The BN orientation degree in the sheet of the thermally conductive sheet of the present invention is preferably 6 to 70. When the BN orientation degree in the sheet of the thermally conductive sheet is 6 to 70, it is possible to suppress that a direction in which the heat conductivity of the aggregated boron nitride particles is low is aligned in a thickness direction of the thermally conductive sheet, and the thermal conductivity of the thermally conductive sheet is deteriorated. From such a viewpoint, the BN orientation degree in the sheet of the thermally conductive sheet of the present invention is more preferably 7 to 60, still more preferably 8 to 50, and even more preferably 10 to 40. The BN orientation degree in the sheet of the thermally conductive sheet can be measured by the method described in Examples described later.

(Dielectric Breakdown Voltage)

The dielectric breakdown voltage of the thermally conductive sheet of the present invention is preferably 15 kV/mm or more. When the dielectric breakdown voltage is 15 kV/mm or more, with recent size reduction of electronic devices and increase in the amount of heat generated by heat generating electronic components, it is possible to meet the strict demand for insulation property of the thermally conductive sheet. From such a viewpoint, the dielectric breakdown voltage of the thermally conductive sheet is more preferably 20 kV/mm or more and still more preferably 25 kV/mm or more. The upper limit value of the range of the dielectric breakdown voltage of the thermally conductive sheet is not particularly limited, and is usually 50 kV/mm. The dielectric breakdown voltage of the thermally conductive sheet can be measured by the method described in Examples described later.

(Thermal Resistance)

The thermal resistance of the thermally conductive sheet of the present invention is preferably 0.07 to 0.12°C/W. When the thermal resistance of the thermally conductive sheet is 0.07 to 0.12°C/W, with recent size reduction of electronic devices and increase in the amount of heat generated by heat generating electronic components, it is possible to meet the strict demand for thermal conductivity of the thermally conductive sheet. From such a viewpoint, the thermal resistance of the thermally conductive sheet is more preferably 0.075 to 0.11°C/W and still more preferably 0.08 to 0.10°C/W. The thermal resistance of the thermally conductive sheet can be measured by the method described in Examples described later.

(Thickness)

The thickness of the thermally conductive sheet of the present invention is not particularly limited, and is preferably 0.1 to 1 mm, more preferably 0.15 to 0.9 mm, and still more preferably 0.2 to 0.8 mm.

(Method for Producing Thermally Conductive Sheet)

The thermally conductive sheet of the present invention can be produced, for example, by a production method including a step (A) of blending a thermally conductive filler, a silicone resin, and an unreacted silicone oil to prepare a thermally conductive resin composition, a step (B) of molding the thermally conductive resin composition into a sheet shape to prepare a thermally conductive resin composition sheet, and a step (C) of heating and pressurizing the thermally conductive resin composition sheet.

(Step (A))

In the step (A), a thermally conductive filler, a silicone resin, and an unreacted silicone oil are blended to prepare a thermally conductive resin composition. The thermally conductive filler, the silicone resin, and the unreacted silicone oil used in the step (A) have already been described, the description thereof is omitted.

(Step (B))

In the step (B), the thermally conductive resin composition is molded into a sheet to prepare a thermally conductive resin composition sheet. For example, the thermally conductive resin composition can be molded into a sheet shape by a doctor blade method or calendering. However, when the thermally conductive filler is aggregated particles, the aggregated particles in the thermally conductive resin composition may be broken when the thermally conductive resin composition passes through a calender roll. Therefore, it is preferable to mold the thermally conductive resin composition into a sheet shape by a doctor blade method.

(Step (C))

In the step (C), the thermally conductive resin composition sheet is heated and pressurized. Thereby, the filling property of the thermally conductive filler in the thermally conductive sheet can be further enhanced, and the thermal conductivity of the thermally conductive sheet can be further improved. From the viewpoint of improving the filling property of the thermally conductive filler, the heating temperature of the thermally conductive resin composition sheet is preferably 120 to 200°C and more preferably 130 to 180°C. The pressure at the time of pressurizing the thermally conductive resin composition sheet is preferably 1 to 25 MPa and more preferably 5 to 20 MPa.

In the step (C), a laminate of the thermally conductive resin composition sheet and a glass cloth may be prepared, and the laminate may be heated and pressurized in vacuum. Thereby, a thermally conductive sheet including a glass cloth can be produced.

Examples

Hereinafter, the present invention will be described in detail with reference to Examples and Comparative Examples. The present invention is not limited to the following Examples.

In the thermally conductive sheets of Examples and Comparative Examples, boron nitride particles were used as the thermally conductive filler. Then, three kinds of raw material boron nitride particles each having a maximum point of a predetermined particle size were mixed to prepare boron nitride particles having three maximum points. The raw material boron nitride particles used as raw materials of boron nitride particles used for the thermally conductive sheets of Examples and Comparative Examples were evaluated as follows.

(Average Particle Size)

For the measurement of the average particle size of the raw material boron nitride particles, a laser diffraction scattering particle size distribution analyzer (LS-13 320) manufactured by Beckman Coulter, Inc. was used. As the obtained average particle size, a value obtained by measuring raw material boron nitride particles without applying a homogenizer before the measurement treatment was adopted as an average particle size value. The obtained average particle size is an average particle size based on a volume statistical value.

The boron nitride particles prepared by mixing three kinds of raw material boron nitride particles were evaluated as follows.

(Crushing Strength of Aggregated Boron Nitride Particles)

The crushing strength of the aggregated boron nitride particles was measured in accordance with JIS R 1639-5:2007. Specifically, the boron nitride particles were sprayed onto a sample stage of a microcompression tester ("MCT-211" manufactured by SHIMADZU CORPORATION), 20 aggregated boron nitride particles were then selected from the boron nitride particles, and a compression test was performed for each particle. Then, the crushing strength ($\sigma$: MPa) was calculated by formula $\sigma = \alpha \times P/(\pi \times d^2)$ from a dimensionless number ($\alpha = 2.48$) variable according to a position in the particle, a crushing test force (P: N), and a particle size (d: $\mu$m). The crushing strengths of 20 inorganic filler components were subjected to Weibull plotting in accordance with JIS R 1625:2010, and the crushing strength at which a cumulative damage rate reached 63.2% was determined as the crushing strength of the boron nitride particles.

(Particle Size Distribution)

For the measurement of the particle size distribution of the boron nitride particles, a laser diffraction scattering particle size distribution analyzer (LS-13 320) manufactured by Beckman Coulter, Inc. was used. Before the measurement of the particle size distribution, a treatment of dispersing boron nitride particles using a homogenizer or the like was not performed.

An unreacted silicone oil was used in the preparation of thermally conductive sheets of Examples and Comparative Examples. The unreacted silicone oil used in the thermally conductive sheets of Examples and Comparative Examples was evaluated as follows.

(Kinematic Viscosity)

The kinematic viscosity of the unreacted silicone oil at 25°C was measured in accordance with the method described in JIS Z 8803:2011.

The thermally conductive sheets of Examples and Comparative Examples were evaluated as follows.

(Storage Elastic Modulus)

Using a dynamic viscoelasticity measuring device (Hitachi High-Tech Science Corporation, DMA7100), measurement was performed at a frequency of 1 Hz in a temperature range of 0°C to +200°C. A measurement sample (7 mm × 40 mm) was cut out from a film having a thickness of about 0.1 to 0.3 mm and measured, and the storage elastic modulus at 50°C was determined. The main measurement parameters involved in the measurement are as follows.

Measurement frequency: 1 Hz
Temperature raising rate: 5°C/min
Sample measurement length: 20 mm
Strain: 0.1%.

(BN Orientation Degree in Sheet)

The BN orientation degree in the sheet was measured using an X-ray diffractometer (ULTIMA-IV manufactured by Rigaku Corporation). A sample cut into 1.5 cm × 1.5 cm was prepared, and the sample was irradiated with X-rays to calculate and evaluate a peak intensity ratio (002)/(100) between the (002) plane and the (100) plane.

(Dielectric Breakdown Voltage)

The dielectric breakdown voltage of the thermally conductive sheet was calculated based on a value measured by a short-time breakdown test (room temperature 23°C) in accordance with JIS C 2110. Evaluation criteria for insulation property are as follows.

⊙: The dielectric breakdown voltage is 20 kV/mm or more
∘: The dielectric breakdown voltage is 10 kV/mm or more and less than 20 kV/mm
×: The dielectric breakdown voltage is less than 10 kV/mm

(Thermal Resistance)

A thermally conductive sheet was disposed between a TO-3 type model heater and a copper plate. Then, the thermally conductive sheet was fastened with a fastening torque of 0.5 N·m using a screw having a nominal diameter of 4 mm. The contact area between one TO-3 type model heater and the heat dissipation sheet was about 6 cm$^2$. Thereafter, power of 15 W was applied to the TO-3 type model heater using a power supply device (manufactured by KIKUSUI ELECTRONICS CORPORATION, Model No.: PMC35-3). Then, a temperature (T1) of the TO-3 type model heater and a temperature (T2) of the copper plate after 10 minutes from the application of the power of 15 W were measured, and the thermal resistance was calculated from the following formula.

$$\text{Thermal resistance (°C/W)} = (T1 - T2)/15$$

(Heat Conductivity)

The heat conductivity of the thermally conductive sheet was measured in accordance with the method described in ASTM D5470:2017.
Evaluation criteria for thermal conductivity are as follows.

⊙: The heat conductivity is 5 W/(m·K) or more
∘: The heat conductivity is 3 W/ (m·K) or more and less than 5 W/(m·K)
×: The heat conductivity is less than 3 W/ (m·K)

(Flexibility)

A sheet cut into 20 mm × 20 mm by a universal material tester (Model 5967 manufactured by Instron Corporation) was subjected to a compression test at a compression speed of 1 mm/min and a pressure of 0.5 MPa, and flexibility was evaluated from a compression ratio.
Evaluation criteria for flexibility are as follows.

∘: The compression ratio is 3% or more
×: The compression ratio is less than 3%

The following materials were prepared as raw materials of the thermally conductive sheet.

(1) Silicone Resin

· Silicone resin containing vinyl groups at both ends thereof: trade name "CF-3110" manufactured by Dow Toray Co., Ltd.

(2) Unreacted Silicone Oil

· Unreacted silicone oil 1: dimethyl silicone oil, trade name "SILICONE FLUID AK1000000" manufactured by Asahi Kasei Wacker, kinematic viscosity: 1 m$^2$/s (1000000 cSt)
· Unreacted silicone oil 2: dimethyl silicone oil, trade name "SILICONE FLUID AK100000" manufactured by Asahi Kasei Wacker, kinematic viscosity: 0.1 m$^2$/s (100000 cSt)

Boron nitride particles A to E having one maximum point, which are raw materials for boron nitride particles having three maximum points, were prepared as follows.

(Boron Nitride Particles A)

The boron nitride particles A were prepared by boron carbide synthesis, a pressurized nitridation step, a decarburization crystallization step as follows.

(Boron Carbide Synthesis Step)

100 parts by mass of orthoboric acid (referred to as boric acid, hereinafter) manufactured by Nippon Denko Co., Ltd. and 35 parts by mass of acetylene black (HS100) manufactured by Denka Company Limited were mixed using a Henschel mixer, the mixture was filled in a graphite crucible and heated in an arc furnace in an argon atmosphere at 2200°C for 5 hours to synthesize boron carbide ($B_4C$). The synthesized boron carbide lump was pulverized with a ball mill for 3 hours, sieved with a sieve mesh into a particle size of 75 $\mu$m or less, washed with aqueous nitric acid solution to remove impurities such as iron, and filtered and dried to prepare a boron carbide powder having an average particle size of 55 $\mu$m.

(Pressurized Nitridation Step)

The synthesized boron carbide was filled in a boron nitride crucible, and then heated in a nitrogen gas atmosphere at 2000°C and 9 atm (0.8 MPa) for 10 hours using a resistance heating furnace to obtain boron carbonitride ($B_4CN_4$).

(Decarburization Crystallization Step)

After 100 parts by mass of the synthesized boron carbonitride and 90 parts by mass of boric acid were mixed using a Henschel mixer, the mixture was filled in a boron nitride crucible, the temperature was raised at a temperature raising rate of 10°C/min from the room temperature to 1000°C and at a temperature raising rate of 2°C/min from 1000°C using a resistance heating furnace under the pressure condition of 0.2 MPa in a nitrogen gas atmosphere, and heating was performed at a firing temperature of 2020°C for a retaining time of 10 hours to synthesize aggregated boron nitride particles in a lump shape formed by an aggregation of primary particles. The synthesized aggregated boron nitride particles were crushed with a Henschel mixer for 15 minutes, and classified using a sieve mesh and with a nylon sieve having a sieve opening of 150 $\mu$m. The fired product was crushed and classified to obtain boron nitride particles A.

The average particle size (D50) of the obtained boron nitride particles A measured by a laser scattering method was 70 $\mu$m. As a result of SEM observation, the obtained boron nitride particles A were aggregated boron nitride particles formed by an aggregation of primary particles. The crushing strength of the obtained boron nitride particles A was 9 MPa.

(Boron Nitride Particles B)

Boric acid, melamine, and calcium carbonate (all of which are special grade reagents) were mixed in a proportion of 70:50:5 in terms of a mass ratio, the temperature was raised in a nitrogen gas atmosphere from room temperature to 1400°C for 1 hour, after retaining at 1400°C for 3 hours, the temperature was raised to 1900°C for 4 hours, and after retaining at 1900°C for 2 hours, cooling to room temperature was performed to produce hexagonal boron nitride. This was crushed, then pulverized, and sieved to prepare boron nitride particles B. The average particle size (D50) of the boron nitride particles B measured by a laser scattering method was 70 $\mu$m. As a result of SEM observation, the boron nitride particles B were aggregated boron nitride particles formed by an aggregation of primary particles. The crushing strength of the boron nitride particles B was 2 MPa.

(Boron Nitride Particles C)

Boron nitride particles C were prepared by the same method as in the boron nitride particles A except that a boron carbide powder having an average particle size of 10 $\mu$m was used. The average particle size (D50) of the obtained boron nitride particles C measured by a laser scattering method was 20 $\mu$m. As a result of SEM observation, the obtained boron nitride particles C were aggregated boron nitride particles formed by an aggregation of primary particles. The crushing strength of the obtained boron nitride particles C was 8 MPa.

(Boron Nitride Particles D)

Boric acid, melamine, and calcium carbonate (all of which are special grade reagents) were mixed in a proportion of 70:50:5 in terms of a mass ratio, the temperature was raised in a nitrogen gas atmosphere from room temperature to 1400°C for 1 hour, after retaining at 1400°C for 3 hours, the temperature was raised to 1900°C for 4 hours, and after retaining at 1900°C for 2 hours, cooling to room temperature was performed to produce hexagonal boron nitride. This was crushed, then pulverized, and sieved to prepare boron nitride particles B and D. The average particle size (D50) of the boron nitride particles D measured by a laser scattering method was 20 $\mu$m. As a result of SEM observation, the boron nitride particles D were aggregated boron nitride particles formed by an aggregation of primary particles. The crushing strength of the boron nitride particles D was 1.5 MPa.

(Boron Nitride Particles E)

As the boron nitride particles E, commercially available boron nitride particles (trade name "HGP" manufactured by Denka Company Limited) were used. The average particle size (D50) of the boron nitride particles E measured by a laser scattering method was 3.0 $\mu$m. As a result of SEM observation, the boron nitride particles E were scaly primary particles.

(Boron Nitride Particles F)

Boron nitride particles F were prepared by the same method as in the boron nitride particles A, except that boric acid mixed with 100 parts by mass of boron carbonitride in the decarburization crystallization step was changed to 45 parts by mass. The average particle size (D50) of the obtained boron nitride particles F measured by a laser scattering method was 70 $\mu$m. As a result of SEM observation, the obtained boron nitride particles F were aggregated boron nitride particles formed by an aggregation of primary particles. The crushing strength of the obtained boron nitride particles C was 18 MPa.
Boron nitride particles 1 and 2 were prepared as follows.

[Boron Nitride Particles 1]

The boron nitride particles A, C, and E were mixed such that the volume ratio of the boron nitride particles A, C, and E was 70:15:15 to prepare boron nitride particles 1.

[Boron Nitride Particles 2]

The boron nitride particles B, D, and E were mixed such that the volume ratio of the boron nitride particles B, D, and E was 70:15:15 to prepare boron nitride particles 2.

[Boron Nitride Particles 3]

The boron nitride particles A, C, and E were mixed such that the volume ratio of the boron nitride particles F, C, and E was 70:15:15 to prepare boron nitride particles 3
A thermally conductive sheet was prepared as follows.

[Preparation of Thermally Conductive Sheet 1]

The boron nitride particles 1, the silicone resin, and the unreacted silicone oil were weighed such that the ratio of the boron nitride particles 1 was 55 parts by volume, the ratio of the silicone resin was 40.5 parts by volume, and the ratio of the unreacted silicone oil was 4.5 parts by volume, and charged into a stirrer (trade name: Three-One Motor manufactured by HEIDON). 1 part by mass of a curing agent (2,5-dimethyl-2,5-bis(t-butylperoxy)hexane, trade name "Trigonox 101" manufactured by Kayaku Nouryon Corporation) with respect to 100 parts by mass of the silicone resin, 0.5 mass% of a silane coupling agent (dimethyldimethoxysilane, trade name "DOWSIL Z-6329 Silane" manufactured by Dow Toray Co., Ltd., viscosity at 25°C: 1 cp) with respect to 100 parts by mass of the total of the boron nitride powder, and 15 parts by mass of water with respect to 100 parts by mass of the silane coupling agent were charged. After 100 parts by mass of toluene with respect to 100 parts by mass of the total of the raw materials described above was further charged into the stirrer, and then mixed for 15 hours using a turbine type stirring blade to prepare a slurry of a thermally conductive resin composition.
The slurry was applied to a PET film (carrier film) having a thickness of 0.05 mm by a doctor blade method in a thickness of 0.02 mm and dried at 75°C for 5 minutes to prepare a sheet-shaped molded body with a PET film attached. Two sheet-shaped molded bodies with a PET film attached were laminated to prepare a laminate. The layer structure of this laminate was PET film/thermally conductive resin composition/thermally conductive resin composition/PET film. Next, the obtained laminate was subjected to a heat press in vacuum (pressure: 3.5 kPa) under conditions of a temperature of 150°C and a pressure of 15 MPa for 30 minutes, and the PET films on the both surfaces were peeled off to obtain a sheet having a thickness of 0.2 mm. Then, the sheet was secondarily heated at normal pressure at 150°C for 4 hours to obtain a thermally conductive sheet.

[Preparation of Thermally Conductive Sheets 2 to 24]

Thermally conductive sheets 2 to 24 were prepared by the same method as in the thermally conductive sheet 1, except that the type and blending amount of the boron nitride particles, the blending amount of the silicone resin, and the type and blending amount of the unreacted silicone oil were changed as shown in Table 1. The samples with different thicknesses had a coating thickness of 0.3 mm.

The evaluation results of the boron nitride particles, the unreacted silicone oil, and the thermally conductive sheet are shown in Tables 1 to 4.

[Table 1]

Table 1

| | | Heat dissipation sheet 1 | Heat dissipation sheet 2 | Heat dissipation sheet 3 | Heat dissipation sheet 4 | Heat dissipation sheet 5 | Heat dissipation sheet 6 |
|---|---|---|---|---|---|---|---|
| | | Example | Example | Example | Example | Example | Example |
| Boron nitride particles | Type | Particles 1 | Particles 1 | Particles 1 | Particles 1 | Particles 1 | Particles 1 |
| | Blending amount (parts by volume) | 55 | 55 | 55 | 55 | 55 | 55 |
| Silicone resin | Blending amount (parts by volume) | 40.5 | 36 | 36 | 31.5 | 31.5 | 27 |
| Unreacted silicone oil | Type | Oil 1 | Oil 1 | Oil 1 | Oil 1 | Oil 1 | Oil 1 |
| | Blending amount (parts by volume) | 4.5 | 9 | 9 | 13.5 | 13.5 | 18 |
| Ratio (volume ratio) (%) of unreacted silicone oil to silicone resin and unreacted silicone oil | | 10 | 20 | 20 | 30 | 30 | 40 |
| Content (mass%) of unreacted silicone oil in thermally conductive sheet | | 2.7 | 5.3 | 5.3 | 8.0 | 8.0 | 10.7 |

(continued)

| | | Heat dissipation sheet 1 | Heat dissipation sheet 2 | Heat dissipation sheet 3 | Heat dissipation sheet 4 | Heat dissipation sheet 5 | Heat dissipation sheet 6 |
|---|---|---|---|---|---|---|---|
| | | Example | Example | Example | Example | Example | Example |
| Evaluation results of boron nitride particles | First maximum value ($\mu$m) | 3 | 3 | 3 | 3 | 3 | 3 |
| | Second maximum value ($\mu$m) | 20 | 20 | 20 | 20 | 20 | 20 |
| | Third maximum value ($\mu$m) | 70 | 70 | 70 | 70 | 70 | 70 |
| | Integrated quantity (vol%) of first frequency | 15 | 15 | 15 | 15 | 15 | 15 |
| | Integrated quantity (vol%) of second frequency | 15 | 15 | 15 | 15 | 15 | 15 |
| | Integrated quantity (vol%) of third frequency | 70 | 70 | 70 | 70 | 70 | 70 |
| | Crushing strength (MPa) of aggregated boron nitride particles | 9 | 9 | 9 | 9 | 9 | 9 |
| Evaluation results of unreacted silicone oil | Kinematic viscosity ($m^2$/s) | 1 | 1 | 1 | 1 | 1 | 1 |

(continued)

| | | Heat dissipation sheet 1 | Heat dissipation sheet 2 | Heat dissipation sheet 3 | Heat dissipation sheet 4 | Heat dissipation sheet 5 | Heat dissipation sheet 6 |
|---|---|---|---|---|---|---|---|
| | | Example | Example | Example | Example | Example | Example |
| Evaluation results of thermally conductive sheet | Thickness (mm) | 0.2 | 0.2 | 0.3 | 0.2 | 0.3 | 0.2 |
| | Storage elastic modulus (Pa) | 1.2E+09 | 1.1E+09 | 1.1E+09 | 9.9E+08 | 1.0E+09 | 9.8E+08 |
| | BN orientation degree in sheet | 19 | 16 | 14 | 16 | 13 | 18 |
| | Dielectric breakdown voltage (kV/mm) | ⊙ | ⊙ | ⊙ | ⊙ | ⊙ | ⊙ |
| | Thermal resistance (°C/W) | 0.10 | 0.09 | 0.12 | 0.09 | 0.10 | 0.09 |
| | Heat conductivity (W/m·K) | ⊙ | ⊙ | ⊙ | ⊙ | ⊙ | ⊙ |
| | Flexibility | ○ | ○ | ○ | ○ | ○ | ○ |

[Table 2]

Table 2

| | | Heat dissipation sheet 7 | Heat dissipation sheet 8 | Heat dissipation sheet 9 | Heat dissipation sheet 10 | Heat dissipation sheet 11 | Heat dissipation sheet 12 |
|---|---|---|---|---|---|---|---|
| | | Example | Example | Example | Example | Example | Example |
| Boron nitride particles | Type | Particles 1 | Particles 1 | Particles 1 | Particles 1 | Particles 1 | Particles 1 |
| | Blending amount (parts by volume) | 55 | 55 | 55 | 55 | 55 | 55 |
| Silicone resin | Blending amount (parts by volume) | 27 | 22.5 | 22.5 | 40.5 | 36 | 36 |
| Unreacted silicone oil | Type | Oil 1 | Oil 1 | Oil 1 | Oil 2 | Oil 2 | Oil 2 |
| | Blending amount (parts by volume) | 18 | 22.5 | 22.5 | 4.5 | 9 | 9 |

(continued)

| | Heat dissipation sheet 7 | Heat dissipation sheet 8 | Heat dissipation sheet 9 | Heat dissipation sheet 10 | Heat dissipation sheet 11 | Heat dissipation sheet 12 |
|---|---|---|---|---|---|---|
| | Example | Example | Example | Example | Example | Example |
| Ratio (volume ratio) (%) of unreacted silicone oil to silicone resin and unreacted silicone oil | 40 | 50 | 50 | 10 | 20 | 20 |
| Content (mass%) of unreacted silicone oil in thermally conductive sheet | 10.7 | 13.3 | 13.3 | 2.7 | 5.3 | 5.3 |
| Evaluation results of boron nitride particles — First maximum value ($\mu$m) | 3 | 3 | 3 | 3 | 3 | 3 |
| Second maximum value ($\mu$m) | 20 | 20 | 20 | 20 | 20 | 20 |
| Third maximum value ($\mu$m) | 70 | 70 | 70 | 70 | 70 | 70 |
| Integrated quantity (vol%) of first frequency | 15 | 15 | 15 | 15 | 15 | 15 |
| Integrated quantity (vol%) of second frequency | 15 | 15 | 15 | 15 | 15 | 15 |
| Integrated quantity (vol%) of third frequency | 70 | 70 | 70 | 70 | 70 | 70 |
| Crushing strength (MPa) of aggregated boron nitride particles | 9 | 9 | 9 | 9 | 9 | 9 |
| Evaluation results of unreacted silicone oil — Kinematic viscosity (m$^2$/s) | 1 | 1 | 1 | 0.1 | 0.1 | 0.1 |

(continued)

| | | Heat dissipation sheet 7 | Heat dissipation sheet 8 | Heat dissipation sheet 9 | Heat dissipation sheet 10 | Heat dissipation sheet 11 | Heat dissipation sheet 12 |
|---|---|---|---|---|---|---|---|
| | | Example | Example | Example | Example | Example | Example |
| Evaluation results of thermally conductive sheet | Thickness (mm) | 0.3 | 0.2 | 0.3 | 0.2 | 0.2 | 0.3 |
| | Storage elastic modulus (Pa) | 9.7E+08 | 5.4E+08 | 5.3E+08 | 1.1E+09 | 8.3E+08 | 8.2E+08 |
| | BN orientation degree in sheet | 17 | 20 | 19 | 18 | 16 | 16 |
| | Dielectric breakdown voltage (kV/mm) | ⊙ | ⊙ | ⊙ | ⊙ | ⊙ | ⊙ |
| | Thermal resistance (°C/W) | 0.11 | 0.09 | 0.10 | 0.11 | 0.09 | 0.11 |
| | Heat conductivity (W/m·K) | ○ | ○ | ○ | ⊙ | ⊙ | ⊙ |
| | Flexibility | ○ | ○ | ○ | ○ | ○ | ○ |

[Table 3]

Table 3

| | | Heat dissipation sheet 13 | Heat dissipation sheet 14 | Heat dissipation sheet 15 | Heat dissipation sheet 16 | Heat dissipation sheet 17 | Heat dissipation sheet 18 |
|---|---|---|---|---|---|---|---|
| | | Example | Example | Example | Example | Example | Example |
| Boron nitride particles | Type | Particles 1 | Particles 1 | Particles 1 | Particles 1 | Particles 1 | Particles 1 |
| | Blending amount (parts by volume) | 55 | 55 | 55 | 55 | 55 | 55 |
| Silicone resin | Blending amount (parts by volume) | 31.5 | 31.5 | 27 | 27 | 22.5 | 22.5 |
| Unreacted silicone oil | Type | Oil 2 | Oil 2 | Oil 2 | Oil 2 | Oil 2 | Oil 2 |
| | Blending amount (parts by volume) | 13.5 | 13.5 | 18 | 18 | 22.5 | 22.5 |

(continued)

| | Heat dissipation sheet 13 | Heat dissipation sheet 14 | Heat dissipation sheet 15 | Heat dissipation sheet 16 | Heat dissipation sheet 17 | Heat dissipation sheet 18 |
|---|---|---|---|---|---|---|
| | Example | Example | Example | Example | Example | Example |
| Ratio (volume ratio) (%) of unreacted silicone oil to silicone resin and unreacted silicone oil | 30 | 30 | 40 | 40 | 50 | 50 |
| Content (mass%) of unreacted silicone oil in thermally conductive sheet | 8.0 | 8.0 | 10.7 | 10.7 | 13.3 | 13.3 |
| Evaluation results of boron nitride particles | First maximum value ($\mu$m) | 3 | 3 | 3 | 3 | 3 | 3 |
| | Second maximum value ($\mu$m) | 20 | 20 | 20 | 20 | 20 | 20 |
| | Third maximum value ($\mu$m) | 70 | 70 | 70 | 70 | 70 | 70 |
| | Integrated quantity (vol%) of first frequency | 15 | 15 | 15 | 15 | 15 | 15 |
| | Integrated quantity (vol%) of second frequency | 15 | 15 | 15 | 15 | 15 | 15 |
| | Integrated quantity (vol%) of third frequency | 70 | 70 | 70 | 70 | 70 | 70 |
| | Crushing strength (MPa) of aggregated boron nitride particles | 9 | 9 | 9 | 9 | 9 | 9 |
| Evaluation results of unreacted silicone oil | Kinematic viscosity ($m^2$/s) | 0.1 | 0.1 | 0.1 | 0.1 | 0.1 | 0.1 |

(continued)

| | | Heat dissipation sheet 13 | Heat dissipation sheet 14 | Heat dissipation sheet 15 | Heat dissipation sheet 16 | Heat dissipation sheet 17 | Heat dissipation sheet 18 |
|---|---|---|---|---|---|---|---|
| | | Example | Example | Example | Example | Example | Example |
| Evaluation results of thermally conductive sheet | Thickness (mm) | 0.2 | 0.3 | 0.2 | 0.3 | 0.2 | 0.3 |
| | Storage elastic modulus (Pa) | 7.8E+08 | 7.8E+08 | 7.3E+08 | 7.3E+08 | 7.0E+08 | 6.8E+08 |
| | BN orientation degree in sheet | 16 | 9 | 16 | 18 | 15 | 19 |
| | Dielectric breakdown voltage (kV/mm) | ⊙ | ⊙ | ⊙ | ⊙ | ○ | ○ |
| | Thermal resistance (°C/W) | 0.09 | 0.11 | 0.08 | 0.11 | 0.07 | 0.10 |
| | Heat conductivity (W/m·K) | ⊙ | ⊙ | ⊙ | ⊙ | ⊙ | ⊙ |
| | Flexibility | ○ | ○ | ○ | ○ | ○ | ○ |

[Table 4]

Table 4

| | | Heat dissipation sheet 19 | Heat dissipation sheet 20 | Heat dissipation sheet 21 | Heat dissipation sheet 22 | Heat dissipation sheet 23 | Heat dissipation sheet 24 |
|---|---|---|---|---|---|---|---|
| | | Comparative Example | Comparative Example | Comparative Example | Comparative Example | Example | Comparative Example |
| Boron nitride particles | Type | Particles 1 | Particles 1 | Particles 2 | Particles 2 | Particles 3 | Particles E |
| | Blending amount (parts by volume) | 55 | 55 | 55 | 55 | 55 | 55 |
| Silicone resin | Blending amount (parts by volume) | 45 | 45 | 45 | 45 | 22.5 | 22.5 |
| Unreacted silicone oil | Type | - | - | - | - | Oil 1 | Oil 1 |
| | Blending amount (parts by volume) | 0 | 0 | 0 | 0 | 22.5 | 22.5 |
| Ratio (volume ratio) (%) of unreacted silicone oil to silicone resin and unreacted silicone oil | | 0 | 0 | 0 | 0 | 50 | 50 |
| Content (mass%) of unreacted silicone oil in thermally conductive sheet | | 0 | 0 | 0 | 0 | 13.3 | 13.3 |
| Evaluation results of boron nitride particles | First maximum value ($\mu$m) | 3 | 3 | 3 | 3 | 3 | 3 |
| | Second maximum value ($\mu$m) | 20 | 20 | 20 | 20 | 20 | - |
| | Third maximum value ($\mu$m) | 70 | 70 | 70 | 70 | 70 | - |
| | Integrated quantity (vol%) of first frequency | 15 | 15 | 15 | 15 | 15 | 100 |
| | Integrated quantity (vol%) of second frequency | 15 | 15 | 15 | 15 | 15 | - |
| | Integrated quantity (vol%) of third frequency | 70 | 70 | 70 | 70 | 70 | - |
| | Crushing strength (MPa) of aggregated boron nitride particles | 9 | 9 | 1.5 | 1.5 | 18 | - |
| Evaluation results of unreacted silicone oil | Kinematic viscosity (m$^2$/s) | - | - | - | - | 1 | 1 |

EP 4 657 518 A1

(continued)

| | | Heat dissipation sheet 19 | Heat dissipation sheet 20 | Heat dissipation sheet 21 | Heat dissipation sheet 22 | Heat dissipation sheet 23 | Heat dissipation sheet 24 |
|---|---|---|---|---|---|---|---|
| | | Comparative Example | Comparative Example | Comparative Example | Comparative Example | Example | Comparative Example |
| Evaluation results of thermally conductive sheet | Thickness (mm) | 0.2 | 0.3 | 0.2 | 0.3 | 0.2 | 0.2 |
| | Storage elastic modulus (Pa) | 1.295E+09 | 1.4E+09 | 2.5E+08 | 2.5E+08 | 1.2E+09 | 1.2E+08 |
| | BN orientation degree in sheet | 16 | 17 | 80 | 75 | 7 | Unmeasurable |
| | Dielectric breakdown voltage (kV/mm) | ○ | ○ | ⊙ | ⊙ | ○ | ⊙ |
| | Thermal resistance (°C/W) | 0.13 | 0.14 | 0.14 | 0.15 | 0.13 | 0.46 |
| | Heat conductivity (W/m·K) | ⊙ | ⊙ | × | × | ⊙ | × |
| | Flexibility | × | × | ○ | ○ | ○ | ○ |

From the above evaluation results, it was found that by containing aggregated boron nitride particles in which primary particles are aggregated, a silicone resin, and an unreacted silicone oil in a thermally conductive sheet, a thermally conductive sheet having high heat conductivity and excellent flexibility is obtained.

**Claims**

1. A thermally conductive sheet comprising: aggregated boron nitride particles in which primary particles are aggregated; a silicone resin; and an unreacted silicone oil.

2. The thermally conductive sheet according to claim 1, wherein a crushing strength of the aggregated boron nitride particles is 5 to 15 MPa.

3. The thermally conductive sheet according to claim 1 or 2, wherein the silicone resin is a radically curable silicone resin.

4. The thermally conductive sheet according to claim 1 or 2, wherein a content of the unreacted silicone oil is 1 to 15 mass%.

5. Aggregated boron nitride particles for the thermally conductive sheet according to claim 1.

FIG. 1

## INTERNATIONAL SEARCH REPORT

| | International application No. |
|---|---|
| | **PCT/JP2024/010452** |

| A. | CLASSIFICATION OF SUBJECT MATTER |
|---|---|

*H01L 23/373*(2006.01)i; *C01B 21/064*(2006.01)i; *C01B 33/12*(2006.01)i; *C08K 3/38*(2006.01)i; *C08L 83/04*(2006.01)i
FI:   H01L23/36 M; C01B33/12 Z; C08L83/04; C08K3/38; C01B21/064 M

According to International Patent Classification (IPC) or to both national classification and IPC

| B. | FIELDS SEARCHED |
|---|---|

Minimum documentation searched (classification system followed by classification symbols)

H01L23/373; C01B21/064; C01B33/12; C08K3/38; C08L83/04

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2022/149435 A1 (DENKA CO., LTD.) 14 July 2022 (2022-07-14)<br>        paragraphs [0010], [0021], [0041] | 5 |
| Y | | 1-4 |
| Y | WO 2019/189626 A1 (BANDO CHEMICAL INDUSTRIES, LTD.) 03 October 2019<br>(2019-10-03)<br>        paragraphs [0027]-[0030], [0056]-[0057], [0064] | 1-4 |
| Y | JP 2015-13949 A (TOKUYAMA CORPORATION) 22 January 2015 (2015-01-22)<br>        paragraph [0037] | 3 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **17 May 2024** | **28 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/010452**

| Patent document cited in search report | | | Publication date (day/month/year) | Patent family member(s) | | | Publication date (day/month/year) |
|---|---|---|---|---|---|---|---|
| WO | 2022/149435 | A1 | 14 July 2022 | US | 2024/0026198 | A1 | |
| | | | | paragraphs [0018], [0030], [0051] | | | |
| | | | | EP | 4253315 | A1 | |
| | | | | CN | 116670233 | A | |
| WO | 2019/189626 | A1 | 03 October 2019 | (Family: none) | | | |
| JP | 2015-13949 | A | 22 January 2015 | (Family: none) | | | |

Form PCT/ISA/210 (patent family annex) (July 2022)

**EP 4 657 518 A1**

**REFERENCES CITED IN THE DESCRIPTION**

**Patent documents cited in the description**

- JP 2020164365 A